# FASCICULE DE BREVET EUROPEEN

(11) **EP 3 296 759 B1**
(45) Date de publication et mention de la délivrance du brevet: **30.09.2020**
(21) Numéro de dépôt: 17188903.3
(22) Date de dépôt: 31.08.2017
(51) Int. Cl.: G01S 7/282, H03K 3/53, G01S 7/40, H03K 3/543

(54) **EMETTEUR RADAR MUNI D'AU MOINS UN TUBE HYPERFRÉQUENCE**
RADARSENDER, DER MIT MINDESTENS EINER HYPERFREQUENZRÖHRE AUSGESTATTET IST
RADAR TRANSMITTER PROVIDED WITH AT LEAST ONE MICROWAVE TUBE

(30) Priorité: 15.09.2016 FR 1601349
(43) Date de publication de la demande: 21.03.2018
(73) Titulaire: Thales, 92400 Courbevoie (FR)
(72) Inventeur: COUTAND, François, 92130 ISSY LES MOULINEAUX (FR); TRANI, Philippe, 78690 LES ESSARTS LE ROI (FR); COTE, Gilles, 78370 PLAISIR (FR); KARTENER, Gilles, 78330 FONTENAY LE FLEURY (FR); DURAND, Alain, 92250 LA GARENNE COLOMBES (FR); BONIFACE, Philippe, 78320 LA VERRIERE (FR)
(74) Mandataire: Brunelli, Gérald

(56) Documents cités:
- FR-A- 1 405 181
- US-A- 3 973 145
- US-A- 4 803 378
- US-A- 5 942 810
- US-B1- 6 495 961

## Description

La présente invention concerne un émetteur radar muni d'au moins un tube hyperfréquence.

Un émetteur radar comprend un tube hyperfréquence et une alimentation à haute tension électrique, et permet d'amplifier un signal hyperfréquence. On entend par signal hyperfréquence, un signal dont la fréquence radioélectrique est très élevée, typiquement supérieure à 10 GHz pour ce type d'application.

La présente invention s'applique particulièrement aux émetteurs radars avec des impulsions très courtes, typiquement d'une durée inférieure à 200 ns et des fréquences de répétition des impulsions, ou "pulses" en langue anglaise sont faibles, typiquement inférieures à 10 kHz.

Dans le tube hyperfréquence, le faisceau d'électrons est émis par une cathode, et une grille, placée devant la cathode, module l'intensité de ce faisceau d'électrons.

L'intensité électrique du courant émis par la cathode varie avec les conditions d'utilisation, ou, en d'autres termes, avec les conditions environnementales, telle la température ambiante, et le vieillissement de la cathode, ou, en d'autres termes des endommagements de la cathode dus notamment à une déformation de la grille et un empoisonnement de la cathode essentiellement par dépôt de baryum sur celle-ci. Ces endommagements entraînent une variation de la puissance hyperfréquence du signal en sortie de l'émetteur radar, au cours du temps d'utilisation de l'émetteur.

Il est connu de réguler la puissance du signal de sortie de l'émetteur radar à partir de la tension de grille de déblocage du faisceau du tube hyperfréquence, mais ce type de régulation a une précision. En effet, la grille sur son support se déforme légèrement au cours du temps lors de l'utilisation du tube, aussi la micropervéance du tube n'est pas constante dans le temps, et par conséquent l'intensité du courant de sortie de la cathode également. Le document US5942810A décrit un dispositif de régulation d'alimentation d'un émetteur radar utilisant un tube hyperfréquence.

Un but de l'invention est de pallier les problèmes précédemment cités, et plus particulièrement de permettre de limiter les baisses de puissance du signal de sortie de l'émetteur radar provenant de son vieillissement.

Aussi, il est proposé, selon un aspect de l'invention, un émetteur radar muni d'au moins un tube hyperfréquence générant un courant pulsé comprenant des périodes avec des impulsions et des périodes sans impulsions comprenant:
- une cathode à grille;
- une alimentation de puissance électrique;
- un module de transformation de l'amplitude dudit courant pulsé de sortie de la cathode (2) en tension continue;
- un régulateur série à résistance variable de régulation d'alimentation de la grille de la cathode;
- un circuit de lecture configuré pour lire une tension électrique de la grille et la diviser par un coefficient constant pour la ramener dans une gamme de tensions électriques comparables à une tension électrique de référence;
- un comparateur, dont la sortie commande ledit régulateur, configuré pour comparer la tension électrique de sortie du module de transformation et la tension électrique de référence, ou pour comparer une tension électrique représentative d'une tension électrique de la grille et la tension de référence;
- un commutateur configuré pour commuter une entrée du comparateur entre la tension électrique de sortie du module de transformation et la tension électrique représentative de la tension électrique de la grille;
- un module de commande dudit commutateur configuré pour commander le commutateur en fonction de la période courante du courant pulsé; et
- une capacité de découplage permettant d'emmagasiner de l'énergie et de lisser la tension d'alimentation de la grille.

Ainsi, la présente invention permet d'asservir le courant cathode du tube hyperfréquence délivré par la cathode sur la tension électrique de référence L'amplitude crête du courant cathode, pour cette application est de la classe 8 ampères. La tension de référence dépend essentiellement du rapport de transformation du tore de lecture du courant cathode et de la résistance de charge associée.

L'invention permet donc de compenser les pertes de puissances de l'émetteur radar dues à son vieillissement.

Dans un mode de réalisation, il est proposé un émetteur radar dans lequel ledit module de transformation de l'amplitude dudit courant pulsé en tension continue comprend un échantillonneur-bloqueur et un circuit magnétique.

Ainsi, l'échantillonneur-bloqueur permet d'obtenir une image précise de la valeur du courant cathode crête (tension continue) dans l'impulsion pour obtenir l'erreur statique visée pour la régulation.

Selon un mode de réalisation, l'échantillonneur-bloqueur comprend au moins un transistor à effet de champ à structure métal-oxyde-semiconducteur.

Dans un mode de réalisation, le circuit magnétique comprend un tore entourant le fil électrique de courant de sortie de la cathode.

Ainsi, la tension électrique au secondaire du bobinage du tore magnétique, chargée par une résistance, est l'image précise de la valeur crête du courant cathode du tube hyperfréquence que l'on souhaite asservir avec l'erreur statique la plus faible

Selon un mode de réalisation, ledit régulateur comprend un ensemble comprenant au moins un transistor à effet de champ à structure métal-oxyde-semiconducteur ou MOSFET pour acronyme de "Metal Oxide Semiconductor Field Effect Transistor" en langue anglaise.

L'utilisation d'un MOSFET s'avère nécessaire car d'une part les temps de commutation doivent être largement inférieurs à la largeur d'impulsions du courant cathode du tube hyperfréquence et d'autre part la résistance série du transistor MOFSET à l'état passant doit être très faible pour ne pas générer une erreur statique incompatible avec le besoin.

Dans un mode de réalisation, ledit commutateur comprend au moins un transistor à effet de champ à structure métal-oxyde-semiconducteur ou MOSFET.

Une telle réalisation du commutateur permet d'obtenir des temps de commutation entre les deux types de régulation compatible du besoin.

Selon un mode de réalisation, ledit commutateur est configuré pour être en position ouverte lorsque le courant pulsé est dans une période avec des impulsions, et en position fermée lorsque le courant pulsé est dans une période sans impulsions.

Ainsi, la régulation en courant est pré-positionnée, par la boucle en tension, même en absence de courant cathode.

L'invention sera mieux comprise à l'étude de quelques modes de réalisation décrits à titre d'exemples nullement limitatifs et illustrés par les dessins annexés sur lesquels :
- la figure 1 illustre schématiquement un émetteur radar selon un aspect de l'invention;
- la figure 2 illustre schématiquement un courant pulsé comprenant des périodes avec impulsions et des périodes sans impulsions;
- la figure 3 illustre schématiquement un régulateur, selon un aspect de l'invention;
- la figure 4 illustre schématiquement un module de transformation de l'amplitude du courant pulsé en tension électrique continue et un module de commande du commutateur, selon un aspect de l'invention; et
- la figure 5 illustre schématiquement un commutateur selon un aspect de l'invention.

Sur l'ensemble des figures, les éléments ayant des références identiques sont similaires. les modes de réalisation décrits sont nullement limitatifs.

Dans la présente description, les caractéristiques et fonctions bien connues de l'homme du métier ne sont pas décrites en détails.

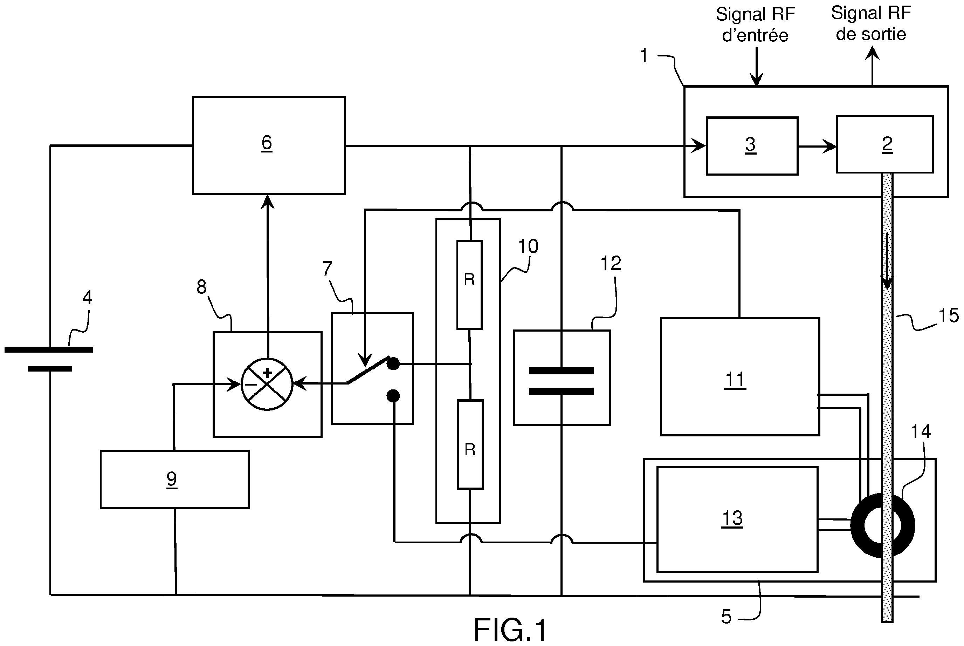

La figure 1 représente un émetteur radar, selon un aspect de l'invention, muni d'au moins un tube hyperfréquence 1, en l'occurrence un tube hyperfréquence 1 générant un courant pulsé comprenant des périodes avec des impulsions et des périodes sans impulsions.

Sur la figure 1, le tube hyperfréquence 1 est représenté de façon simplifiée ne faisant pas apparaître les électrodes collectrices d'électrons et la connectique associée.

L'émetteur radar comprend un tube hyperfréquence 1 muni d'une cathode 2 à grille 3, et une alimentation de puissance électrique 4, ainsi qu'un module 5 de transformation de l'amplitude du courant pulsé en tension électrique continue.

Un régulateur 6 série à résistance variable permet de réguler l'alimentation électrique de la grille 3 de la cathode 2. Le régulateur 6 est monté en série avec l'alimentation de puissance électrique amont 4. Il se comporte comme une résistance variable qui permet d'ajuster et de réguler la tension électrique d'alimentation de la grille 3.

La tension continue délivrée par le module 5 de transformation de l'amplitude du courant pulsé, est fournie en entrée d'un commutateur 7, dont la sortie est transmise en entrée d'un comparateur 8, le comparateur 8 effectuant une comparaison entre la sortie du commutateur 7 et une référence de tension électrique 9.

La référence de tension électrique 9 fournit au comparateur 8 une tension électrique de référence 9 qui est stable pendant l'utilisation (stable en température) et qui peut être ajustable au réglage initial pour pouvoir choisir le point de fonctionnement (choix initial de la consigne de l'amplitude du courant de cathode 2 et de la tension électrique d'alimentation de la grille ").

Le régulateur 6 délivre en sortie une tension électrique de commande de la grille 3. Un circuit 10 de lecture est configuré pour lire une tension électrique de la grille 3 et la diviser par un coefficient constant prédéterminé pour la ramener dans une gamme de tensions électriques comparables à la tension électrique de référence 9.

Le circuit 10 de lecture peut être réalisé par un pont diviseur de tension constitué de résistances stables en température.

L'émetteur radar 1 comprend en outre un module de commande 11 du commutateur 7 configuré pour commander le commutateur 7 en fonction de la période courante du courant pulsé.

L'émetteur radar comprend également une capacité de découplage 12 permettant d'emmagasiner de l'énergie et de lisser la tension d'alimentation de la grille 3.

Le module 5 de transformation de l'amplitude du courant pulsé comprend par exemple un échantillonneur-bloqueur 13 et un circuit magnétique 14, tel un tore entourant un câble 15 du courant pulsé de sortie de la cathode 3.

L'échantillonneur-bloqueur 13 permet de convertir le signal pulsé de sortie du circuit magnétique 14 en une tension électrique continue. Il échantillonne et mesure l'amplitude de chaque impulsion p et la convertit en une tension électrique de sortie qui reste constante jusqu'à l'impulsion p suivante. La variation d'amplitude entre deux impulsions étant faible, la tension électrique de sortie cet échantillonneur-bloqueur 13 peut être vue comme une tension continue.

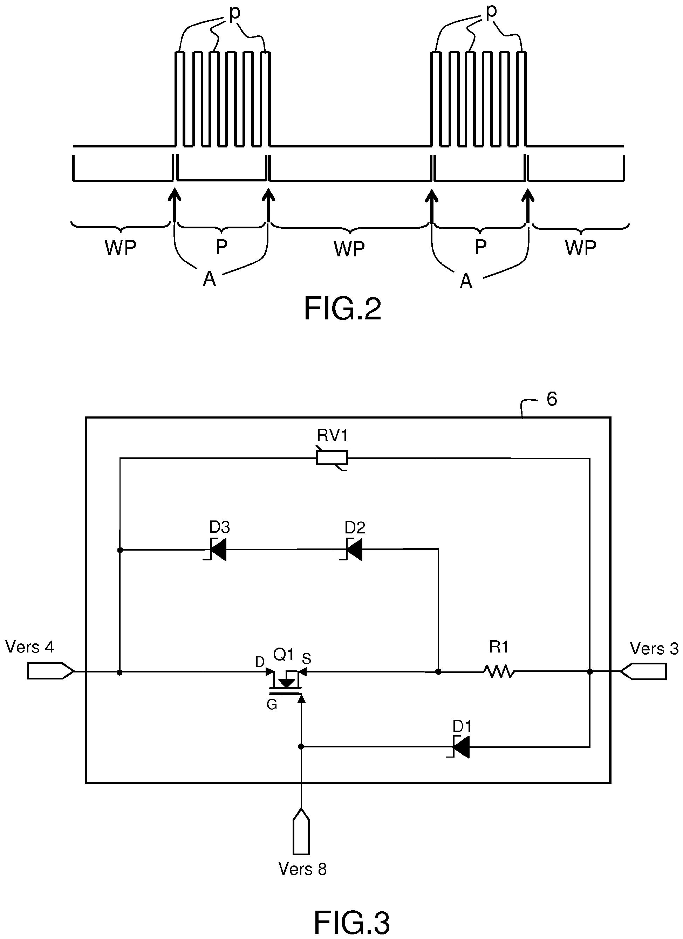

La figure 2 représente schématiquement un courant pulsé comprenant des périodes P avec des impulsions p et des périodes WP dépourvues d'impulsions. Les flèches A représentent une commutation du commutateur 7, qui est en position ouverte lorsque le courant pulsé est dans une période P avec des impulsions p, et en position fermée lorsque le courant pulsé est dans une période WP sans impulsions. En d'autres termes une période P avec des impulsions p correspond à une période durant laquelle le faisceau de l'émetteur radar est débloqué, et une période WP dépourvue d'impulsions correspond à une période durant laquelle le faisceau de l'émetteur radar est bloqué. L'invention permet d'utiliser des impulsions d'une durée inférieure à 500 ns.

Comme illustré sur la figure 3, le régulateur 6 peut comprendre un ensemble comprenant au moins un transistor à effet de champ à structure métal-oxyde-semiconducteur ou MOSFET Q1, au moins une résistance de protection, et au moins une diode Transil et/ou une varistance. Le drain du MOSFET Q1 est connectée à l'alimentation de puissance 4. En l'espèce, le régulateur 6 comprend deux diodes Transil D2 et D3 en série, disposées en parallèle d'un MOSFET Q1, le tout en série avec une résistance R1, le tout en parallèle avec une varistance ou résistance variable RV1. En outre, une diode Transil D1 est disposée entre le pôle de la résistance R1 fournissant la tension électrique d'alimentation de la grille 3 et la grille du MOSFET Q1 reliée à la tension électrique de sortie du comparateur 8. L'autre pôle de la résistance R1 est relié à la source du MOSFET Q1.

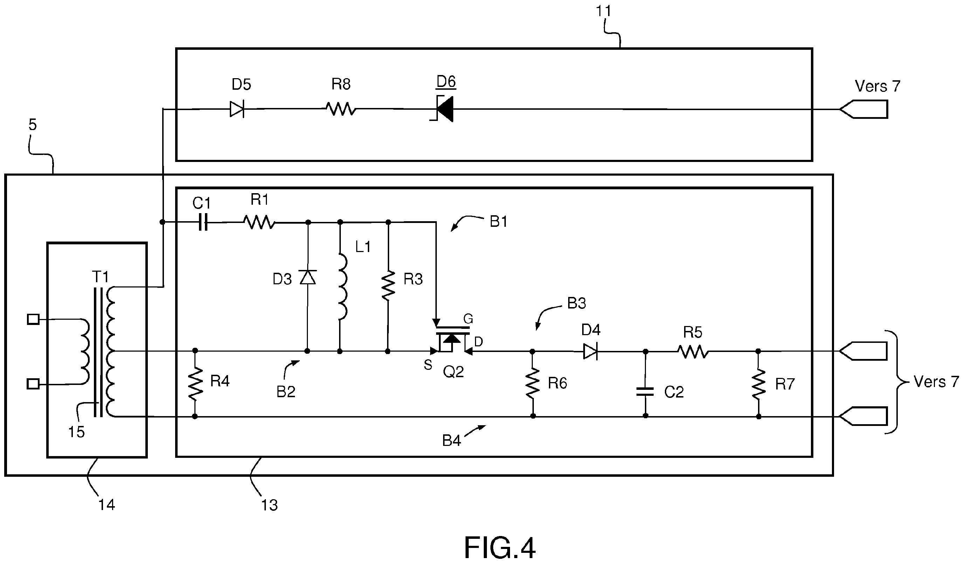

La figure 4 représente schématiquement un mode de réalisation du module 5 de transformation de l'amplitude du courant pulsé en tension électrique continue et le module de commande 11 du commutateur 7.

Le module 5 de transformation de l'amplitude du courant pulsé en tension électrique continue comprend le circuit magnétique 14 comprenant un tore T1 entourant un câble 15 du courant pulsé de sortie de la cathode 3, ainsi que l'échantillonneur-bloqueur 13.

L' échantillonneur-bloqueur 13 comprend un MOSFET Q2 dont la grille G est reliée à une première branche B1, la source S est reliée à une deuxième branche B2 et le drain D est relié à une troisième branche B3.

La première branche B1 comprend un condensateur C1 relié en série avec une résistance R2 reliée à la grille G du MOSFET Q2. Le condensateur C1 est également relié au circuit magnétique 14.

La deuxième branche B2 relie le circuit magnétique 14 à la source S du MOSFET Q2, et la troisième branche B3 relie le drain D du MOSFET Q2 à une première sortie du module 5 de transformation de l'amplitude du courant pulsé en tension électrique continue.

L' échantillonneur-bloqueur 13 comprend une quatrième branche B4 reliant le circuit magnétique 14 à une deuxième sortie du module 5 de transformation de l'amplitude du courant pulsé en tension électrique continue, les deux sorties du module 5 délivrant donc la tension électrique continue de sortie du module 5.

Une diode D3 est montée entre la première branche B1 et la deuxième branche B2, ainsi qu'une inductance L1 et une résistance R3, donc toutes trois disposées en parallèles.

Une résistance R4 est disposée entre la deuxième branche B2 et la quatrième branche B4.

En partant du drain D du MOSFET Q2 vers la première sortie du module 5, sont disposées une diode D4 et une résistance R5. Entre le drain D du MOSFET Q2 et la diode D4 est disposée une résistance R6 reliant la troisième branche B3 et la quatrième branche B4. Entre la diode D4 et la résistance R5 est disposée un condensateur C2 reliant la troisième branche B3 et la quatrième branche B4. Entre la résistance R5 et la première sortie du module 5 est disposée une résistance R7 reliant la troisième branche B3 et la quatrième branche B4.

Le module de commande 11 du commutateur 7 peut comprendre une diode D5, une résistance R8 et une diode Transil D6 montées en série entre le circuit magnétique 14 et la sortie du module de commande 11.

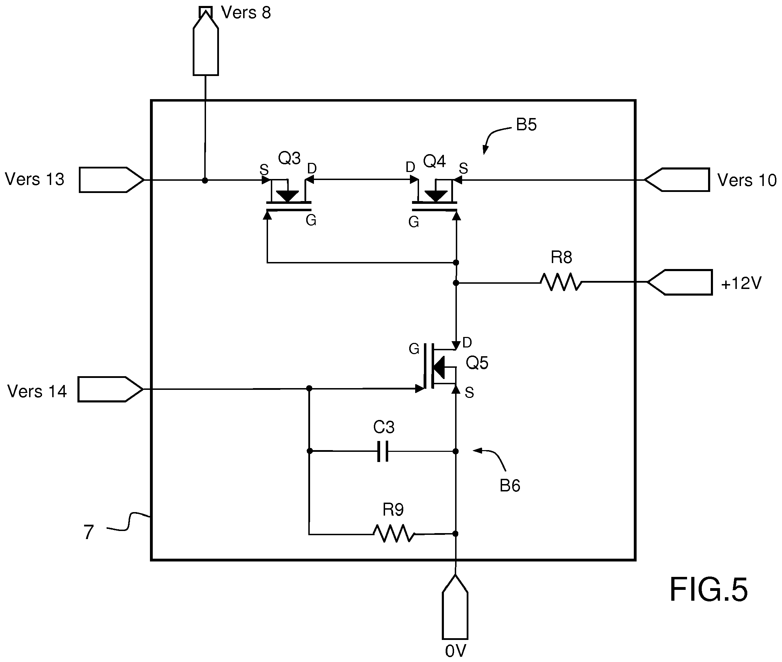

Sur la figure 5 est représenté schématiquement un mode de réalisation du commutateur 7.

Le commutateur 7 comprend une cinquième B5 comprenant deux MOSFET Q3 et Q4 reliés en série par leur drains respectifs D, la source S du MOSFET Q" recevant la tension électrique de sortie de l'échantillonneur-bloqueur 13, et la source S du MOSFET Q4 recevant la tension électrique de sortie du circuit de lecture 10.

Une sixième branche B6 du commutateur 7 comprend un MOSFET Q5 dont le drain D et reliés aux deux grilles G des MOSFET Q3 et Q4, la source S et reliée à une entrée 0 V, le transistor Q5 permettant suivant son état de rendre passant ou bloqué les transistors Q3 et Q4, et la grille G est reliée à la tension électrique délivrée par le module de commande 11. La sixième branche B6 est également reliée, par l'intermédiaire d'une résistance R8 à une tension électrique de 12 V. Le transistor Q5 permettant suivant son état de rendre passant ou bloqué les transistors Q3 et Q4 par application d'une tension électrique continue de 12 V ou par application d'une tension électrique nulle (entrée 0 V).

En outre, la sixième branche B6 comprend un condensateur C3 et une résistance R9 montés en parallèle, reliés d'une part à la grille G du MOSFET Q5, et d'autre part à la source S du MOSFET Q5, entre la source S du MOSFET Q5 et la tension électrique de 0 V.

La présente invention agit sur la régulation de la tension électrique de commande de la grille 3 du tube hyperfréquence1 au moyen du régulateur 6 comprenant en l'espèce le transistor MOSFET Q1. Ce transistor Q1 est commandé par un amplificateur d'erreur ou comparateur 8 dont l'entrée négative est la tension électrique de référence 9 ajustable.

La présente invention possède deux modes de fonctionnement : un mode de régulation du courant électrique de la cathode 2 (lorsque le faisceau de l'émetteur est débloqué) et un mode de régulation de la tension électrique de commande de la grille 3 (lorsque l'émetteur est au repos et que le faisceau est bloqué).

Durant une période P avec des impulsions p correspondant à une période durant laquelle le faisceau de l'émetteur radar est débloqué, la présente invention maintient constant le courant électrique de la cathode 3.

Durant une période WP dépourvue d'impulsions correspondant à une période durant laquelle le faisceau de l'émetteur radar est bloqué, la présente invention maintient constant la tension électrique de commande de la grille 3.

L'élément de base du mode de régulation du courant électrique de la cathode 2 est le module 5 de transformation de l'amplitude du courant pulsé en tension électrique continue comprenant le circuit magnétique 14 en matériau nanocristallin et l'échantillonneur-bloqueur 13 permettant d'acquérir et de mémoriser l'amplitude des impulsions p courtes.

Au déblocage du faisceau, le commutateur 7 permet d'injecter la tension électrique de sortie de l'échantillonneur-bloqueur 13 sur l'entrée positive du comparateur 8. L'invention permet alors d'asservir l'intensité du courant électrique de la cathode 2 sur la valeur de la tension électrique de référence 9. L'amplitude crête du courant cathode, pour cette application est de la classe 8 ampères. Le niveau de la tension électrique de référence 9 est fixée par l'utilisateur en fonction de l'amplitude crête du courant cathode désirée. La tension électrique de sortie de l'échantillonneur-bloqueur dépend essentiellement du rapport de transformation du tore 14 de lecture du courant cathode et de la résistance R4.

Au blocage du faisceau, le circuit passe en mode de régulation en tension électrique . Le commutateur 7 permet d'injecter sur l'entrée positive du comparateur 8 une autre tension électrique, à savoir la tension électrique issue du circuit de lecture 10 , en l'espèce un pont diviseur, de la tension électrique de commande de la grille 3 du tube hyperfréquence1. L'invention régule alors la tension électrique de commande de la grille 3 sur la tension électrique de référence 9.

Ainsi, la présente invention permet de garder, au cours du temps, une puissance souhaitée délivrée par l'émetteur radar.

## Revendications

1. Emetteur radar muni d'au moins un tube hyperfréquence (1) générant un courant pulsé comprenant des périodes (P) avec impulsions (p) et des périodes (WP) sans impulsions, comprenant:
- une cathode (2) à grille (3);
- une alimentation de puissance électrique (4);
- un module (5) de transformation de l'amplitude dudit courant pulsé de sortie de la cathode (2) en tension continue;
- un régulateur (6) série à résistance variable de régulation d'alimentation de la grille (3) de la cathode (2);
- un circuit de lecture (10) configuré pour lire une tension électrique de la grille (3) et la diviser par un coefficient constant pour la ramener dans une gamme de tensions électriques comparables à une tension électrique de référence (9);
- un comparateur (8), dont la sortie commande ledit régulateur (6), configuré pour comparer la tension électrique de sortie du module de transformation (5) et la tension électrique de référence (9), ou pour comparer une tension électrique représentative d'une tension électrique de la grille (3) et la tension de référence (9);
- un commutateur (7) configuré pour commuter une entrée du comparateur (8) entre la tension électrique de sortie du module de transformation (5) et la tension électrique représentative de la tension électrique de la grille (3);
- un module de commande (11) dudit commutateur (7) configuré pour commander le commutateur (7) en fonction de la période courante (P, WP) du courant pulsé; et
- une capacité de découplage (12) permettant d'emmagasiner de l'énergie et de lisser la tension d'alimentation de la grille (3).

2. Emetteur radar selon la revendication 1, dans lequel ledit module (5) de transformation de l'amplitude dudit courant pulsé en tension continue comprend un échantillonneur-bloqueur (13) et un circuit magnétique (14).

3. Emetteur radar selon la revendication 2, dans lequel l'échantillonneur-bloqueur (13) comprend au moins un transistor à effet de champ à structure métal-oxyde-semiconducteur.

4. Emetteur radar selon la revendication 2 ou 3, dans lequel le circuit magnétique comprend un tore (T1) entourant le fil électrique (15) de courant de sortie de la cathode (2).

5. Emetteur radar selon l'une des revendications précédentes, dans lequel ledit régulateur (6) comprend au moins un transistor à effet de champ à structure métal-oxyde-semiconducteur (MOSFET).

6. Emetteur radar selon l'une des revendications précédentes, dans lequel ledit commutateur (7) comprend au moins un transistor à effet de champ à structure métal-oxyde-semiconducteur (MOSFET).

7. Emetteur radar selon l'une des revendications précédentes, dans lequel ledit commutateur (7) est configuré pour être en position ouverte lorsque le courant pulsé est dans une période avec des impulsions, et en position fermée lorsque le courant pulsé est dans une période sans impulsions.

## Patentansprüche

1. Radarsender, ausgestattet mit mindestens einer Hyperfrequenzröhre (1), welche einen gepulsten Strom erzeugt, umfassend Perioden (P) mit Impulsen (p) und Perioden (WP) ohne Impulse, Folgendes umfassend:
- eine Kathode (2) mit Gitter (3);
- eine elektrische Leistungsspeisung (4);
- ein Modul (5) zur Transformation der Amplitude des gepulsten Ausgangstroms der Kathode (2) in Gleichspannung;
- einen Reihenregler (6) mit variablem Widerstand zur Regelung der Speisung des Gitters (3) der Kathode (2);
- einen Leseschaltkreis (10), konfiguriert zum Lesen einer elektrischen Spannung des Gitters (3) und Teilen derselben durch einen konstanten Koeffizienten, um sie in einen Bereich elektrischer Spannungen zurückzubringen, welche mit einer elektrischen Referenzspannung (9) vergleichbar sind;
- einen Komparator (8), dessen Ausgang den Regler (6) steuert, konfiguriert zum Vergleichen der elektrischen Ausgangsspannung des Transformationsmoduls (5) mit der elektrischen Referenzspannung (9), oder zum Vergleichen einer elektrischen Spannung, welche eine elektrische Spannung des Gitters (3) darstellt, mit der Referenzspannung (9);
- einen Umschalter (7), konfiguriert zum Umschalten eines Eingangs des Komparators (8) zwischen der elektrischen Ausgangsspannung des Transformationsmoduls (5) und der elektrischen Spannung, welche die elektrische Spannung des Gitters (3) darstellt;
- ein Steuerungsmodul (11) des Umschalters (7), konfiguriert zum Steuern des Umschalters (7) in Abhängigkeit von der laufenden Periode (P, WP) des gepulsten Stroms; und
- eine Entkopplungskapazität (12), welche es ermöglicht, die Energie zu speichern und die Speisungsspannung des Gitters (3) zu glätten.

2. Radarsender nach Anspruch 1, wobei das Modul (5) zur Transformation der Amplitude des gepulsten Stroms in Gleichspannung eine Abtast-Halte-Schaltung (13) und einen magnetischen Schaltkreis (14) umfasst.

3. Radarsender nach Anspruch 2, wobei die Abtast-Halte-Schaltung (13) mindestens einen Transistor mit Feldeffekt mit Metalloxid-Halbleiterstruktur umfasst.

4. Radarsender nach Anspruch 2 oder 3, wobei der magnetische Schaltkreis einen Torus (T1) umfasst, welcher den Ausgangsstrom-Draht (15) der Kathode (2) umgreift.

5. Radarsender nach einem der vorhergehenden Ansprüche, wobei der Regler (6) mindestens einen Transistor mit Feldeffekt mit Metalloxid-Halbleiterstruktur (MOSFET) umfasst.

6. Radarsender nach einem der vorhergehenden Ansprüche, wobei der Umschalter (7) mindestens einen Transistor mit Feldeffekt mit Metalloxid-Halbleiterstruktur (MOSFET) umfasst.

7. Radarsender nach einem der vorhergehenden Ansprüche, wobei der Umschalter (7) konfiguriert ist, um in einer geöffneten Position zu sein, wenn der gepulste Strom sich in einer Periode mit Impulsen befindet, und in einer geschlossenen Position, wenn der gepulste Strom sich in einer Periode ohne Impulse befindet.

## Claims

1. Radar transmitter which is provided with at least one microwave tube (1) which generates a pulsed current comprising periods (P) with pulses (p) and periods (WP) without pulses, comprising:
- a cathode (2) having a grid (3);
- an electrical power supply (4);
- a module (5) for converting the amplitude of the pulsed output current of the cathode (2) into direct voltage;
- a series controller (6) with variable resistance for controlling the supply of the grid (3) of the cathode (2);
- a reading circuit (10) which is configured to read an electrical voltage of the grid (3) and to divide it by a constant coefficient in order to move it into a range of electrical voltages which are comparable to an electrical reference voltage (9);
- a comparator (8), whose output commands the controller (6), configured to compare the electrical output voltage of the conversion module (5) with the electrical reference voltage (9), or to compare an electrical voltage which is representative of an electrical voltage of the grid (3) with the reference voltage (9);
- a commutator (7) which is configured to commutate an input of the comparator (8) between the electrical output voltage of the conversion module (5) and the electrical voltage which is representative of the electrical voltage of the grid (3);
- a control module (11) of the commutator (7) which is configured to control the commutator (7) in accordance with the current period (P, WP) of the pulsed current; and
- a decoupling capacitor (12) which enables the energy to be stored and the supply voltage of the grid (3) to be smoothed

2. Radar transmitter according to claim 1, wherein the module (5) for converting the amplitude of the pulsed current into direct voltage comprises a sampler/blocker (13) and a magnetic circuit (14).

3. Radar transmitter according to claim 2, wherein the sampler/blocker (13) comprises at least one metal oxide semiconductor field effect transistor.

4. Radar transmitter according to claim 2 or 3, wherein the magnetic circuit comprises a ring (T1) which surrounds the electrical wire (15) of the output current of the cathode (2).

5. Radar transmitter according to any one of the preceding claims, wherein the controller (6) comprises at least one metal oxide semiconductor field effect transistor (MOSFET)

6. Radar transmitter according to any one of the preceding claims, wherein the commutator (7) comprises at least one metal oxide semiconductor field effect transistor (MOSFET).

7. Radar transmitter according to any one of the preceding claims, wherein the commutator (7) is configured to be in an open position when the pulsed current is in a period with pulses and in a closed position when the pulsed current is in a period without pulses.
